**Europäisches Patentamt**

**European Patent Office**

**Office européen des brevets**

(19)

(11) Veröffentlichungsnummer : **0 330 059 B1**

(12)

# EUROPÄISCHE PATENTSCHRIFT

(45) Veröffentlichungstag der Patentschrift :
**25.01.95 Patentblatt 95/04**

(51) Int. Cl.⁶ : **G03F 7/033**

(21) Anmeldenummer : **89102548.8**

(22) Anmeldetag : **15.02.89**

(54) **Durch Strahlung polymerisierbares Gemisch und daraus hergestelltes Aufzeichnungsmaterial.**

(30) Priorität : **24.02.88 DE 3805706**

(43) Veröffentlichungstag der Anmeldung :
**30.08.89 Patentblatt 89/35**

(45) Bekanntmachung des Hinweises auf die
Patenterteilung :
**25.01.95 Patentblatt 95/04**

(84) Benannte Vertragsstaaten :
**AT BE CH DE ES FR GB IT LI NL SE**

(56) Entgegenhaltungen :
**DE-A- 3 503 115**
**DE-A- 3 512 684**
**DE-A- 3 741 926**
**US-A- 4 239 849**

(73) Patentinhaber : **MORTON INTERNATIONAL, INC.**
**100 North Riverside Plaza**
**Chicago Illinois 60606-1596 (US)**

(72) Erfinder : **Geissler, Ulrich, Dr.**
**Altenauer Strasse 34**
**D-6203 Hochheim (DE)**
Erfinder : **Wiezer, Hartmut, Dr.**
**Am Herzhain 1b**
**D-6239 Eppstein-Vockenhausen (DE)**

(74) Vertreter : **Weber, Dieter, Dr. et al**
**Weber, Dieter, Dr.,**
**Seiffert, Klaus, Dipl.-Phys.,**
**Lieke, Winfried, Dr.**
**Postfach 61 45**
**D-65051 Wiesbaden (DE)**

EP 0 330 059 B1

## Beschreibung

Durch Strahlung polymerisierbares Gemisch und daraus hergestelltes Aufzeichnungsmaterial

Die Erfindung betrifft ein durch aktinische Strahlung, insbesondere durch Licht polymerisierbares Gemisch, das als wesentliche Bestandteile

a) eine radikalisch polymerisierbare Verbindung mit mindestens einer endständigen ethylenisch ungesättigten Gruppe und mit einem Siedepunkt oberhalb 100 °C bei Normaldruck,

b) eine Verbindung, die unter Einwirkung von aktinischer Strahlung die Polymerisation der Verbindung (a) zu initiieren vermag, und

c) ein wasserunlösliches, in wäßrig-alkalischen Lösungen lösliches gesättigtes Mischpolymerisat als Bindemittel

enthält.

Photopolymerisierbare Gemische der genannten Gattung sind bekannt und werden u. a. zur Herstellung von photopolymerisierbaren Druckplatten und Photoresistmaterialien verwendet. Ein wichtiges Anwendungsgebiet für derartige Gemische ist die Herstellung von Trockenphotoresistmaterialien.

In der DE-A-20 64 080 sind derartige Gemische beschrieben, die als Bindemittel Mischpolymerisate von Methacrylsäure und Alkylmethacrylaten mit mindestens vier Kohlenstoffatomen in der Alkylgruppe, bevorzugt Terpolymerisate von Methacrylsäure, Methyl- oder Ethylmethacrylat und einem Alkylmethacrylat mit 4 bis 15 Kohlenstoffatomen in der Alkylgruppe enthalten.

Um die Entwickelbarkeit in wäßrig-alkalischen Medien zu erreichen, wird eine Säurezahl im Bereich von 150 bis 250 als notwendig angegeben. Dabei werden bei Schichtdicken von 20 μm oder darüber stets Polymere mit Säurezahlen oberhalb 200 eingesetzt. Die verwendeten Entwickler sind zumeist besonders aktiv, z. B. wäßrige Lösungen von Natriummetasilikat und organischen Zusätzen.

In der DE-A-23 63 806 sind ähnliche Gemische beschrieben, die zur Reduzierung des Kaltflusses im unbelichteten Zustand Terpolymerisate aus Methacrylsäure, einem Alkylmethacrylat und einem weiteren Monomeren enthalten, dessen zugehöriges Homopolymerisat eine Glastemperatur von mindestens 80 °C aufweist. Als solche Monomere werden insbesondere Styrol, substituierte Styrole und Acrylnitril genannt. Auch hier werden Säurezahlen von 170 bis 250 empfohlen.

Ähnliche Gemische auf Basis obengenannter Mischpolymerisate mit einem mittleren Molekulargewicht im Bereich von etwa 50.000 bis 200.000 und Säurezahlen im Bereich von vorzugsweise 170 bis 250 sind in der DE-A 34 27 519 beschrieben.

Bei allen Bindemitteln mit hoher Säurezahl geht mit der erwünschten leichten Entwickelbarkeit eine geringere Resistenz der lichtgehärteten Bereiche gegen alkalische Lösungen, z. B. gegen den Entwickler oder gegen alkalische Ätzlösungen, einher.

In der DE-B 25 17 656 werden weitere ähnliche Gemische beschrieben, die zur Herstellung von Trockenresistmaterialien bestimmt sind und als Bindemittel eine Kombination von zwei sauren Polymeren erfordern, von denen unter bestimmten Bedingungen das eine in verdünnter wäßriger Natronlauge löslich, das andere unlöslich ist. Naturgemäß ist die Herstellung einer Mischung, die zwei Bindemittel unterschiedlicher Löslichkeit enthalten muß, technisch aufwendiger, und sie ist eher der Gefahr einer Entmischung beim Stehen in Lösung oder während des Trocknungsvorgangs ausgesetzt als eine Mischung mit einem einheitlichen Bindemittel. Auch kann die Gefahr bestehen, daß sich Anteile des schwerer löslichen Polymeren aus der Lösung im Entwickler ausscheiden und dessen weitere Verwendung stören.

In der DE-A-30 28 136 werden ähnliche photopolymerisierbare Gemische beschrieben, die zur Trockenresistherstellung geeignet sind. Sie enthalten als polymerisierbare Verbindungen u. a. Polyethylenglykoldi(meth)acrylate. Als Bindemittel werden Copolymere von (Meth)acrylsäure und Alkyl-(meth)acrylaten eingesetzt, insbesondere Terpolymerisate aus Methacrylsäure, Methylmethacrylat und einem Alkyl(meth)acrylat mit längerer Alkylgruppe. Die dort eingesetzten Polymeren haben relativ hohe Glastemperaturen und verleihen dadurch dem lichtvernetzenden Gemisch eine relativ hohe Sprödigkeit. Diese wird durch einen verhältnismäßig hohen Monomergehalt, insbesondere durch die genannten stark weichmachenden Monomeren kompensiert, doch werden dadurch andere Eigenschaften, wie die Reesistenz gegen wäßrige, z. B. alkalische Behandlungsflüssigkeiten oder der Kaltfluß, verschlechtert.

In der DE-A-2 164 518 werden photopolymerisierbare Gemische beschrieben, die Polymere mit seitenständigen (Meth)acrylsäure-estergruppen enthalten. Die dort beschriebenen Gemische werden zu Flachdruckplatten mit Schichtdicken von höchstens 3 μm verarbeitet. Die gesättigten Grundpolymeren, aus denen die ungesättigten Polymere hergestellt werden, enthalten Einheiten von ungesättigten Carbonsäuren, (Meth)acrylsäureestern, (Meth)acrylnitril, Vinylaromaten und dergleichen.

Die DE-A-3 503 115 beschreibt eine photopolymerisierbare Zusammensetzung, die eine additionspolymerisierbare ungesättigte Verbindung mit mindestens zwei ethylenisch ungesättigten Doppelbindungen im Molekül, einen Photopolymerisationsinitiator und ein Bindemittel enthält, welches letzteres ein Copolymer mit einem Molekulargewicht (Gewichtsmittel) von 5000 bis 5 Millionen aus 5 bis 70 Mol-% mindestens einer Methacrylat- oder Benzylmethacrylateinheit, 5 bis 70 Mol.-% mindestens einer Acrylateinheit und 20 bis 60 Mol-% mindestens einer $\alpha,\beta$-ethylenisch ungesättigten Carbonsäureeinheit ist.

Die DE-A-3 512 684 betrifft eine photopolymerisierbare Harzmasse mit 40 bis 85 Gew.-% eines ein Copolymer aus Methylmethacrylat, Methylacrylat und Methacrylsäure umfassenden Bindemittelharzes, 15 bis 60 Gew.-% eines vernetzbaren Monomers, welches mindestens zwei ethylenisch ungesättigte Gruppen im Molekül aufweist, und 0,5 bis 10 Gew.-%, bezogen auf die Gesamtmenge der beiden anderen Bestandteile, eines Photoinitiators.

Schließlich beschreibt die US-A-4 239 849 eine photopolymerisierbare Zusammensetzung in der Form eines trockenen Filmes mit 10 bis 60 Gewichtsteilen wenigstens einer additionspolymerisierbaren ethylenisch ungesättigten Verbindung mit einem Siedepunkt oberhalb 100 °C, mit einem freie Radikale erzeugenden Polymerisationsinitiator und mit 40 bis 90 Gewichtsteilen eines makromolekularen polymeren Bindemittels aus 40 bis 60 Teilen eines Monomers vom Styroltyp, 15 bis 45 % eines Alkylacrylats, Alkylmethacrylats, Hydroxyalkylacrylats oder Hydroxyalkylmethacrylats und 15 bis 40 % eines $\alpha,\beta$-ungesättigten carboxylhaltigen Monomers mit 3 bis 15 Kohlenstoffatomen.

Die Eignung photopolymerisierbarer Gemische für Trockenphotoresistmaterialien hängt von der richtigen gegenseitigen Abstimmung mehrerer Eigenschaften ab, z. B. Schichtweichheit, Folienhaftung, Kupferhaftung, Flexibilität, Entwickelbarkeit, Beständigkeit gegen Ätzlösungen und galvanische Bäder, Eignung zum Überspannen von Bohrlöchern (Tenting) und Entschichtbarkeit (Strippbarkeit). Die bekannten photopolymerisierbaren Gemische, die in wäßrig-alkalischen Lösungen verarbeitet werden können, haben einen oder mehrere derfolgenden Nachteile:

- zu starke Klebrigkeit der Resistschicht
- schlechte Haftung der Photopolymerschicht zur Polyesterträgerfolie
- ungenügende Kupferhaftung
- Sprödigkeit im belichteten Zustand
- lange Entwicklungszeiten
- mangelhafte Ätz- und Galvanoresistenz
- zu geringe Zähigkeit für Tenting
- schlechtes Strippverhalten.

Aufgabe der Erfindung war es, ein durch Strahlung polymerisierbares Gemiscn vorzuschlagen, das zur Herstellung von Trockenphotoresistmaterialien geeignet ist und das eine leichte Entwickelbarkeit in rein wäßrig-alkalischen Lösungen mit einer guten Resistenz gegen alkalische Ätzmedien verbindet. Das Gemisch sollte in seinen bevorzugten Ausführungsformen auch keinen der vorstehend genannten Nachteile aufweisen.

Gegenstand der Erfindung ist ein durch Strahlung polymerisierbares Gemisch, das als wesentliche Bestandteile

a) eine radikalisch polymerisierbare Verbindung mit mindestens einer endständigen ethylenisch ungesättigten Gruppe und mit einem Siedepunkt oberhalb 100 °C bei Normaldruck,

b) eine Verbindung, die unter Einwirkung von aktinischer Strahlung die Polymerisation der Verbindung (a) zu initiieren vermag, und

c) ein wasserunlösliches, in organischen Lösemitteln und wäßrig-alkalischen Lösungen, bevorzugt in 1 %iger Sodalösung, lösliches gesättigtes Mischpolymerisat

enthält.

Das erfindungsgemäße Gemisch ist dadurch gekennzeichnet, daß das Mischpolymerisat Einheiten aus

c1) 12 - 27 Gew.-% einer $\alpha,\beta$-ungesättigten aliphatischen Carbonsäure,

c2) 5 - 60 Gew. -% eines Alkylmethacrylats mit 1 bis 6 C-Atomen in der Alkylgruppe.

c3) 20 - 50 Gew.-% eines Alkylacrylats mit 4 bis 8 C-Atomen in der Alkylgruppe und

c4) 1 - 20 Gew.-% eines ggf. substituierten Styrols

enthält, eine Säurezahl von 78 bis 176 und eine Glastemperatur von 290 bis 330 K hat.

Das Mischpolymerisat enthält als ungesättigte aliphatische Carbonsäure c1 bevorzugt Acrylsäure, Methacrylsäure, Crotonsäure, Sorbinsäure, Maleinsäure, Itaconsäure oder Halbester der genannten Dicarbonsäuren.

Besonders vorteilhaft ist die Methacrylsäure oder ein Gemisch von Acryl- und Menacrylsäure, das bis zu 50 % Acrylsäure enthält.

Die Alkylmethacrylate (c2) haben vorzugsweise 1 bis 4 Kohlenstoffatome in der Alkylgruppe. Besonders bevorzugt wird Methylmethacrylat.

Bevorzugte Alkylacrylate (c3) sind Butylacrylat und Ethylhexylacrylat.

Als Komponente (c4) wird beispielsweise Vinyltoluol, Vinylxylol, $\alpha$-Methylstyrol, p-Chlorstyrol, o-Methoxystyrol, m-Bromstyrol oder p-Ethylstyrol eingesetzt, wobei das unsubstituierte Styrol bevorzugt ist.

Der Mengenanteil der Komponente (c1) beträgt bevorzugt 17 bis 25 Gew.-%; der Mengenanteil an Komponente (c2) beträgt vorzugsweise 20 bis 50 Gew.-%, der Mengenanteil an Komponente (c3) vorzugsweise 25 bis 45 Gew.-%, der Mengenanteil an Komponente (c4) bevorzugt 1 bis 10 Gew.-%. Resistschichten mit Styrol-haltigen Bindemitteln zeigen eine besonders gute Resistenz gegen ammoniakalische Ätzmedien.

Die Säurezahl der Polymeren liegt, entsprechen den angegebenen Mengenanteilen von c1, im Bereich von 78 bis 176, vorzugsweise bei 98 bis 176, insbesondere bei 111 bis 163.

Damit die Mischpolymerisate den Anforderungen an die Verarbeitung im Trockenresistverfahren genügen, ist es erforderlich, daß ihre Glastemperatur Tg innerhalb eines bestimmten Bereichs liegt. Die Tg-Werte von Mischpolymerisaten lassen sich näherungsweise aus den Tg-Werten der Homopolymerisate der einzelnen Komponenten nach der folgenden Formel berechnen:

$$\frac{100}{Tg_{MP}} = \frac{m_A}{Tg_A} + \frac{m_B}{Tg_B} + \frac{m_C}{Tg_C} + \dots$$

Dabei bedeuten

$Tg_{MP}$      Glastemperatur des Mischpolymerisats (in Kelvin)

$Tg_{A\,(B,\,C\,..)}$      Glastemperatur des Homopolymerisats von A (B, C usw.) (in Kelvin)

$m_{A\,(B,\,C\,..)}$      Mengenanteil an A (B, C usw.) im Mischpolymerisat in Gew.-%.

Die berechneten Tg-Werte des Mischpolymerisats liegen zwischen 290 und 330 K, insbesondere zwischen 305 und 330K.

Dabei müssen die Tg-Werte durch sorgfältige Abstimmung der Natur und Mengenanteile der einzelnen Monomeren eingestellt werden. Besonders kritisch ist dies bei den Terpolymeren, die Keine Komponente c4 enthalten. Hier muß die Art und Menge der "weichen" Komponente c3 genau auf die Art und Menge der "harten" Komponente c2 abgestimmt werden. Wenn z. B. Methylmethacrylat als bevorzugte Komponente c2 eingesetzt wird, so sollte das Produkt aus der Different der Glastemperaturen von c2 und c3 und dem Mengenanteil von c3 in Prozent mindestens 4000 betragen:

$$(Tg_{c2} - Tg_{c3}) \times m_{c3} \geqq 4000.$$

Durch Einhaltung dieser Beziehung wird gewährleistet, daß bei Komponenten c3 mit höherer Glastemperatur des Homopolymerisats, z. B. Ethylacrylat, entsprechend höhere Mengen eingesetzt werden, damit das Terpolymere nicht zu spröde wird.

Auch der Mengenanteil an c1 hat auf dieses Verhältnis einen erheblichen Einfluß, da die bevorzugte Komponente, Methacrylsäure, eine relativ hohe Glastemperatur einbringt. Grundsätzlich sollte daher auch das vorstehend bezeichnete Produkt um so größer sein, je höher die Säurezahl des Terpolymeren ist. Der Mengenanteil an c1 kann innerhalb der angegebenen Grenzen auf die geforderten Eigenschaften des fertigen Gemischs eingestellt werden. Wenn ein besonders leicht mit schwach alkalischen Entwicklern entwickelbares Material gewünscht wird, sollte die Säurezahl mehr im oberen Teil, wenn eine höhere Ätzfestigkeit gegenüber alkalischen Medien gefordert wird, mehr im unteren Teil des Bereichs liegen.

Die Glastemperaturen der den einzelnen Monomeren entsprechenden homopolymerisate wurden aus dem "Polymer Handbook" von J. Brandrup und E.H. Immergut, Teil III, S. 144 ff entnommen. Im einzelnen wurden der Berechnung in den Beispielen die folgenden Werte zugrundegelegt:

|  | Tg (K) |
|---|---|
| Polymethacrylsäure | 501 |
| Polyacrylsäure | 379 |
| Polymethylmethacrylat (ataktisch) | 378 |
| Polybutylmethacrylat (ataktisch) | 293 |
| Polyhexylmethacrylat | 268 |
| Polyethylacrylat (konventionell) | 249 |
| Polybutylacrylat | 219 |
| Polyethylhexylacrylat | 223 |
| Polyoctylacrylat | 208 |
| Polydecylacrylat | 230 * |

\* aus "Thermoplastische Methacrylat-Festharze" von
G. Kühl und H.-D. Christian in Farbe - Lack 12/1986,
S. 1142 ff.

Die mittleren Molekulargewichte (Mw) der Mischpolymerisate liegen vorzugsweise im Bereich von 50.000 - 200.000, bestimmt durch Gelchromotographie. Die Mischpolymerisate können durch übliche technische Polymerisationsverfahren, z. B. in Lösungs- oder Fällungsmitteln oder durch Polymerisation in der Masse in Gegenwart eines radikalbildenden Polymerisationsinitiators hergestellt werden.

Die Herstellung erfolgt in üblicher Weise in flachen Behältern, um eine bessere Temperaturkontrolle zu ermöglichen. Als Initiatoren werden in bekannter Weise Peroxide oder Azoverbindungen verwendet, die beim Erwärmen Radikale bilden. Um eine gleichmäßige Molekulargewichtsverteilung zu erhalten, ist es zweckmäßig, eine kleine Menge eines Kettenreglers, z. B. einer Mercaptoverbindung zuzusetzen. Auch kann man eine kleine Menge, z. B. weniger als 10 Gew.-% des Monomerengemisches, eines Lösungsmittels, z. B. Wasser oder einen niederen Alkohol, zusetzen. Die Temperatur kann zwischen etwa 30 und 130 °C liegen.

Die erfindungsgemäßen Gemische enthalten polymerisierbare Verbindungen mit vorzugsweise mindestens zwei endständigen ethylenischen Doppelbindungen. Als polymerisierbare Verbindungen werden im allgemeinen Ester der Acryl- oder Methacrylsäure mit mehrwertigen, vorzugsweise primären, Alkoholen verwendet. Beispiele für geeignete mehrwertige Alkohole sind Ethylenglykol, Propylenglykol, Butandiol-1,4, Butandiol-1,3, Diethylenglykol, Triethylenglykol oder Polypropylenglykole mit Molekulargewichten von etwa 200 bis 1.000, Neopentylglykol, Glycerin, Trimethylolethan und -propan, Pentaerythrit, Bisphenol-A-Derivate sowie Umsetzungsprodukte dieser Verbindungen mit Ethylenoxid und/oder Propylenoxid. Besonders geeignet sind Urethangruppen enthaltende Bisacrylate und Bismethacrylate, die durch Umsetzung von 1 mol eines Diisocyanats mit 2 mol Hydroxyalkylacrylat oder -methacrylat erhalten werden. Das Diisocyanat kann auch ein oligomeres, durch Umsetzen eines Diols mit einem molaren Überschuß an monomerem Diisocyanat erhaltenes Produkt sein. Derartige und ähnliche Urethangruppen enthaltende Monomere sind in den DE-A-20 64 079, 28 22 190, 30 48 502 und 35 40 480 beschrieben. Vorzugsweise sollte das Gemisch mindestens 40 %, insbesondere mindestens 60 %, bezogen auf den Gesamtmonomerengehalt, an Monomeren mit mindestens einer Urethangruppe im Molekül enthalten.

Als durch Strahlung, insbesondere aktinisches Licht aktivierbare Polymerisationsinitiatoren in dem erfindungsgemäßen Gemisch können eine Viehzahl von Substanzen Verwendung finden. Beispiele sind Benzoin und seine Derivate, Benzophenon/Michlers Keton-, Thioxanthon/p-Dialkylaminobenzoesäureester-Kombinationen, Trichlormethyl-s-triazine, Trihalogenmethylgruppen enthaltende Carbonylmethylenheterocyclen, z. B. 2-(p-Trichlormethylbenzoylmethylen)-3-ethyl-benzthiazolin, Acridinderivate, z. B. 9-Phenyl-acridin, 9-p-Methoxy-phenylacridin, 9-Acetylamino-acridin, Benz(a)acridin; Phenazinderivate, z. B. 9,10-Dimethyl-benz(a)phenazin, 10-Methoxy-benz(a)phenazin, Chinoxalinderivate, z. B. 6,4′,4″-Trimethoxy-2,3-diphenylchinoxalin, 4′,4″-Dimethoxy-2,3-diphenyl-5-azachinoxalin, Chinazolinderivate oder Chinolinderivate, z. B. 3-Benzyliden-9-phenyl-2,3-dihydro-1H-cyclopenta[b]chinolin. Die Initiatoren werden allgemein in einer Menge von 0,01 bis 10, vorzugsweise von 0,05 bis 4 Gew.-% bezogen auf die nicht flüchtigen Bestandteile des Gemisches, eingesetzt.

Das erfindungsgemäße Gemisch enthält im allgemeinen 40 bis 80, bevorzugt 50 bis 75, insbesondere 60 bis 70 Gew.-% Bindemittel (c) und 20 bis 60, bevorzugt 25 bis 50, insbesondere 30 bis 40 Gew.-% polymerisierbare Verbindungen (a), bezogen jeweils auf die Gesamtmenge an nicht flüchtigen Bestandteilen.

Das Gemisch kann als übliche weitere Bestandteile Polymerisationsinhibitoren, sonstige Stabilisatoren, Wasserstoffdonatoren, sensitometrische Regler, Farbstoffe, Leukofarbstoffe, Photooxydationsmittel, z. B. Tribrommethylphenylsulfon, Pigmente, Weichmacher und thermisch aktivierbare Vernetzungsmittel enthalten.

Als aktinische Strahlung, gegenüber der das erfindungsgemäße Gemisch empfindlich ist, kommt jede elektromagnetische Strahlung in Betracht, deren Energie zur Auslösung einer Polymerisation ausreicht. Geeignet sind insbesondere sichtbares und ultraviolettes Licht, Röntgen- und Elektronenstrahlung. Auch Laserstrahlung im sichtbaren und UV-Bereich kann verwendet werden. Bevorzugt wird kurzwelliges sichtbares und nahes UV-Licht.

Als Schichtträger für mit dem erfindungsgemäßen Gemisch hergestellte Aufzeichnungsmaterialien sind beispielsweise Aluminium, Stahl, Zink, Kupfer, Siebe oder Kunststoffolien, z. B. aus Polyethylenterephthalat, geeignet. Die Trägeroberfläche kann chemisch oder mechanisch vorbehandelt werden, um die Haftung der Schicht richtig einzustellen.

Das erfindungsgemäße Gemisch findet bevorzugt Anwendung als trocken übertragbares Photoresistmaterial. Dazu kann es in bekannter Weise als vorgefertigte, übertragbare Trockenresistfolie auf das zu bearbeitende Werkstück, z. B. auf Leiterplatten-Basismaterial, aufgebracht werden. Im allgemeinen wird zur Herstellung des Trockenresistmaterials eine Lösung des Gemisches in einem Lösemittel auf einen geeigneten Schichtträger, z. B. eine Polyesterfolie, aufgebracht und getrocknet. Die Schichtdicke der Resistschicht kann etwa 10 bis 80, vorzugsweise 20 bis 60 μm betragen. Die freie Oberfläche der Schicht wird vorzugsweise mit einer Deckfolie, z. B. aus Polyethylen oder Polypropylen, abgedeckt. Das fertige Laminat kann als Großrolle gespeichert und bei Bedarf zu Resistrollen beliebiger Breite zerschnitten werden.

Die Folien lassen sich mit in der Trockenresisttechnik üblichen Geräten verarbeiten. In einer handelsüblichen Laminiervorrichtung wird die Deckfolie abgezogen und die Photoresistschicht auf gebohrtes, verkupfertes Basismaterial laminiert. Die so präparierte Platte wird dann durch eine Vorlage belichtet und nach Abziehen der Trägerfolie in bekannter Weise entwickelt.

Als Entwickler sind wäßrige, vorzugsweise wäßrig-alkalische Lösungen, z. B. von Alkaliphosphaten, -carbonaten oder -silikaten, geeignet, denen gegebenenfalls kleine Mengen, z. B. bis zu 10 Gew.-% an mit Wasser mischbaren organischen Lösungsmitteln oder Netzmitteln zugesetzt werden können. Besonders bevorzugt werden wäßrige Lösungen von Alkalicarbonaten.

Die erfindungsgemäßen Gemische lassen sich für die verschiedensten Anwendungsgebiete einsetzen. Mit besonderem Vorteil werden sie in Form eines Trockenresistfilms zur Herstellung von Reservagen, d. h. Ätzschutzschichten oder Galvanoreserven, auf metallischen Trägern, z. B. Kupfer, verwendet.

Die erfindungsgemäßen Trockenresistmaterialien sind aufgrund optimaler Schichtkonsistenz gut verarbeitbar. Durch gute Haftung der Schichten zur Polyesterfolie wird ein Lifting (Abheben) der Folie beim Zuschneiden laminierter Platten vermieden. Die Schichten zeigen eine gute Kupferhaftung im unbelichteten und belichteten Zustand. Kurze Entwicklungs- und Entschichtungszeiten (Strippzeiten) erlauben einen hohen Durchsatz bei der Leiterplattenproduktion. Neben ausgezeichneter Ätz- und Galvanoresistenz sind die erfindungsgemäßen Trockenresistschichten auch für anspruchsvolle Tentinganwendungen einsetzbar. Als Ätzresist für ammoniakalische Ätzmedien werden besonders Trockenresistschichten auf Basis Styrol enthaltender Polymerisate bevorzugt.

Die erfindungsgemäßen Gemische zeichnen sich gegenüber dem ihnen am nächsten kommenden Stand der Technik gemäß DE-A 20 64 080, 23 63 806 und 34 27 519 durch besonders schnelle Entwickelbarkeit in Verbindung mit auch sonst hervorragenden Eigenschaften bei der Anwendung als Trockenresist aus. Dies wird darauf zurückgeführt, daß die Mischpolymeren trotz ihrer relativ niedrigen Säurezahlen eine bessere Alkalilöslichkeit aufweisen als entsprechende bekannte Polymere.

Es ist überraschend gegenüber den Lehren der DE-B 25 17 656, daß diese Vorteile mit nur einem Bindemittel erzielt werden können.

Das erfindungsgemäße Gemisch weist auch eine gute Ätzresistenz im belichteten Zustand gegenüber alkalischen, insbesondere ammoniakalischen Ätzmedien auf, wie sie bei der Verarbeitung von Trockenresist üblich sind. Diese Eigenschaft wird in überraschendem Maße durch die Anwesenheit eines vierten, aromatischen Monomeren (c4) im Bindemittel, von Styrol oder einem substituierten Styrol, verbessert. Dabei wird die rasche Entwickelbarkeit praktisch nicht beeinträchtigt.

Das erfindungsgemäße Gemisch eignet sich besonders gut zur Anwendung im Trockenresistverfahren. Es ist auch für andere Anwendungen geeignet, z. B. zur Herstellung von Photoresistlösungen, von Druckformen, Reliefbildern, Siebdruckschablonen und Farbprüffolien.

Die folgenden Beispiele erläutern bevorzugte Ausführungsformen des erfindungsgemäßen Gemisches und ihre Anwendung. Wenn nichts anderes angegeben ist, sind Prozentzahlen und Mengenverhältnisse in Gewichtseinheiten zu verstehen. Gewichtsteile (Gt) und Volumenteile (Vt) stehen im Verhältnis von g zu cm$^3$.

Beispiel

Die folgenden Beschichtungslösungen wurden hergestellt:

| | |
|---|---|
| 6,3 Gt | eines der unten angegebenen Polymeren, zugesetzt als 31 %ige Lösung (18,4 Gt) in Ethanol/Butanon 1:1, |
| 1,85 Gt | des Diurethans aus 2 mol Hydroxyethylmethacrylat und 1 mol 2,2,4-Trimethylhexamethylendiisocyanat, |
| 1,11 Gt | des Umsetzungsprodukts aus 1 mol Hydroxyethylmethacrylat, 6 mol Ethylenoxid und 1 mol Butylisocyanat, |
| 0,74 Gt | Trimethylolpropan-tris-acryloyloxyethylether, |
| 0,035 Gt | 9-Phenylacridin, |
| 0,081 Gt | Leukokristallviolett, |
| 0,01 Gt | 1',3',3-Trimethyl-6-nitro-8-methoxy-spiro[2H-1-benzopyran-2,2'-indolin], |
| 0,005 Gt | Viktoriareinblau FGA und |
| 0,01 Gt | Tribommethylphenylsulfon in |
| 3 Gt | Ethanol und |
| 3 Gt | Butanon |

Folgende Polymere wurden eingesetzt:

| Poly-meres | MAS* | MMA* | Styrol | EHA* | BA* | Tg (K) (ber.) | Säure-zahl (ber.) |
|---|---|---|---|---|---|---|---|
| 1 | 20 | 40 | – | 25 | 15 | 306 | 130 |
| 2 | 20 | 45 | – | 20 | 15 | 315 | " |
| 3 | 20 | 50 | – | 15 | 15 | 325 | " |
| 4 | 20 | 35 | 5 | 25 | 15 | 306 | " |
| 5 | 20 | 40 | 5 | 20 | 15 | 315 | " |
| 6 | 20 | 45 | 5 | 15 | 15 | 325 | " |
| 7 | 25 | 23 | 5 | 27 | 15 | 306 | 163 |
| 8 | 25 | 33 | 5 | 22 | 15 | 315 | " |
| 9 | 25 | 38 | 5 | 17 | 15 | 325 | " |
| 10 | 25 | 28 | 10 | 22 | 15 | 315 | " |
| 11 | 25 | 18 | 20 | 22 | 15 | 315 | " |

* MAS = Methacrylsäure
  MMA = Methylmethacrylat
  EHA = Ethylhexylacrylat
  BA = Butylacrylat

Die Lösungen wurden auf biaxial verstreckte und thermofixierte Polyethylenterephthalatfolien von 25 μm

Stärke so aufgeschleudert, daß nach dem Trocknen bei 100 °C jeweils ein Schichtgewicht von 43 g/m$^2$ erhalten wurde.

Die so hergestellten Trockenresistfolien wurden mit einer handelsüblichen Laminiervorrichtung bei 115° C auf mit 35 μm starker Kupferfolie kaschierte Phenolharz-Schichtstoffplatten laminiert.

Folgende Resisteigenschaften wurden geprüft:

## 1. Entwicklungszeit $t_E$

Nach Abziehen der Polyesterfolien wurden die Schichten in 1 %iger Natriumcarbonatlösung in einem Sprühentwicklungsgerät entwickelt. Die Zeit bis zum vollständigen Ablösen der unbelichteten Resistschichten entspricht der Entwicklungszeit $t_E$.

## 2. Entschichtungszeit (Strippzeit) $t_S$

Die beschichteten Leiterplatten-Zuschnitte (5 x 15 cm) wurden vollflächig 6 s mittels einer 5-kW-Metallhalogenidlampe in einem Vakuumkopierrahmen belichtet. Nach einer Haltezeit von 90 Minuten wurden die Polyesterfolien abgezogen und die freigelegten Schichten anschließend in einem Sprühentwicklungsgerät mit 1 %iger Natriumcarbonatlösung behandelt (1,5 x $t_E$). Zur Entschichtung der mit Entwickler behandelten Platten wurden 200 ml Entschichterlösung (3 %ige KOH) in ein 200 ml fassendes Becherglas von 6 cm Durchmesser eingefüllt und auf 50 °C erwärmt. Anschließend wurde die Lösung mit einem Magnetrührer gerührt, und eine der entwickelten Platten wurde darin eingetaucht. Das Ende der Schichtablösung wurde notiert.

## 3. Ammoniakalische Atzresistenz

Die beschichteten Leiterplatten (35 μm Basiskupfer) wurden unter einer Strichvorlage mit Linien und Abständen zwischen 100 und 500 μm 6 s belichtet.

Nach der Belichtung wurden die Polyesterfolien abgezogen und die Schichten mit 1 %iger Natriumcarbonatlösung in einem Sprühentwicklungsgerät entwickelt. Die Behandlungszeit entsprach 1,5 x $t_E$.

Geätzt wurde in einer handelsüblichen Durchlaufätzvorrichtung mit ammoniakalischer Kupferchloridlösung bei 45 °C und pH 8,3 und dem 1,5-fachen der Ätzzeit für 35 μm Basiskupfer. Beurteilt wurde, inwieweit Resistbahnen nach dem Ätzen abgelöst waren.

Die Ergebnisse sind in der folgenden Tabelle zusammengefaßt:

| Poly-meres | Entwicklungszeit $t_E$ (s) | Entschichtungszeit $t_S$ (s) | Ätzresistenz | |
|---|---|---|---|---|
| | | | pH 8,3 | pH 8,5 |
| 1 | 40 | 47 | + | − |
| 2 | 40 | 35 | + | − |
| 3 | 40 | 38 | + | − |
| 4 | 40 | 50 | + | + |
| 5 | 40 | 44 | + | + |
| 6 | 40 | 44 | + | + |
| 7 | 50 | 59 | 0 | − |
| 8 | 50 | 58 | − | − |
| 9 | 50 | 45 | − | − |
| 10 | 50 | 30 | − | |
| 11 | 50 | 36 | − | |

+ keine Resistbahnen abgelöst

0 Resistbahnen teilweise abgelöst

− Resistbahnen vollständig abgelöst

Die beschriebenen Trockenresistfolien wurden mit einer handelsüblichen Laminiervorrichtung bei 115 °C auf mit 35 µm starker Kupferfolie kaschierte Phenolharz-Schichtstoffplatten Laminiert und mittels einer 5-kW-Metallhalogenidlampe in einem Vakuumkopierrahmen 6 s belichtet. Als Vorlage diente eine Strichvorlage mit Linienbreiten und Abständen bis herab zu 80 µm.

Nach der Belichtung wurde jeweils die Polyesterfolie abgezogen und die Schicht mit 1 %iger Natriumcarbonatlösung in einem Sprühentwicklungsgerät mit der 1,5-fachen Entwicklungszeit (1,5 $t_E$) entwickelt.

Die Platten wurden dann 30 s mit Leitungswasser gespült, 30 s in einer 15 %igen Ammoniumperoxydisulfat-Lösung angeätzt, erneut mit Wasser gespült, 30 s in 10 %ige Schwefelsäure getaucht und sodann nacheinander in den folgenden Elektrolytbädern galvanisiert:

1. 60 Minuten in einem Kupferelektrolytbad der
   Firma Schlötter, Geislingen/Steige,
   Typ "Glanzkupfer-Bad"
   Stromdichte: 2,5 A/dm²
   Metallaufbau: ca. 30 µm
   Temperatur: Raumtemperatur
2. 15 Minuten in einem Bleizinnbad LA der
   Firma Schlötter, Geislingen/Steige
   Stromdichte: 2 A/dm²
   Metallaufbau: 15 µm
   Temperatur: Raumtemperatur

Die Platten zeigten keinerlei Unterwanderungen oder Beschädigungen.

Die Platten konnten sodann in 3%iger KOH-Lösung bei 50 °C entschichtet und das freigelegte Kupfer in den üblichen Ätzmedien weggeätzt werden.

Vergleichsbeispiel

Die Entwicklungszeiten von Resistschichten, hergestellt analog Beispiel 3 unter Einsatz von Bindemitteln auf Basis Methacrylsäure/Methylmethacrylat/Hexylmethacrylat, sind in der folgenden Tabelle zusammenge-

faßt:

| Poly- meres | MAS | MMA | HMA* | Tg (K) (ber.) | Säurezahl (ber.) | Entwick- lungszeit (s) | Tenting |
|---|---|---|---|---|---|---|---|
| 43 | 20 | 29 | 51 | 326 | 130 | über 360 | nicht einsetzbar |
| 44 | 25 | 21 | 54 | 326 | 163 | 150 | |

HMA* = Hexylmethacrylat

Die beiden Resistschichten sind für Tentinganwendungen nicht geeignet. Bereits beim Abziehen der Polyesterfolie platzen die belichteten freitragenden Schichtbereiche.

**Patentansprüche**

1. Durch Strahlung polymerisierbares Gemisch, das als wesentliche Bestandteile
   a) eine radikalisch polymerisierbare Verbindung mit mindestens einer endständigen ethylenisch ungesättigten Gruppe und einem Siedepunkt oberhalb 100 °C bei Normaldruck,
   b) eine Verbindung, die unter Einwirkung von aktinischer Strahlung die Polymerisation der Verbindung (a) zu initiieren vermag, und
   c) ein wasserunlösliches, in organischen Lösemitteln und in wäßrigalkalischen Lösungen lösliches gesättigtes Mischpolymerisat
   enthält, **dadurch gekennzeichnet**, daß das Mischpolymerisat Einheiten aus
   c1) 12 - 27 Gew.-% einer $\alpha,\beta$-ungesättigten aliphatischen Carbonsäure,
   c2) 5 - 60 Gew.-% eines Alkylmethacrylats mit 1 bis 6 C-Atomen in der Alkylgruppe,
   c3) 20 - 50 Gew.-% eines Alkylacrylats mit 4 bis 8 C-Atomen in der Alkylgruppe und
   c4) 1 - 20 Gew.-% eines gegebenenfalls substituierten Styrols
   enthält sowie eine Säurezahl von 78 bis 176 und eine Glastemperatur von 290 bis 330 K aufweist.

2. Gemisch nach Anspruch 1, **dadurch gekennzeichnet**, daß das Mischpolymerisat Einheiten (cl) aus Acrylsäure, Methacrylsäure, Crotonsäure, Sorbinsäure, Maleinsäure, Itaconsäure oder einem Halbester einer der genannten Dicarbonsäuren enthält.

3. Gemisch nach Anspruch 1, **dadurch gekennzeichnet**, daß es als Bestandteil (a) einen Acryl- oder Methacrylsäureester enthält.

4. Gemisch nach Anspruch 3, **dadurch gekennzeichnet**, daß der Bestandteil (a) mindestens teilweise aus einer Verbindung mit mindestens zwei endständigen ethylenisch ungesättigten Gruppen besteht.

5. Gemisch nach Anspruch 3, **dadurch gekennzeichnet**, daß der Bestandteil (a) mindestens 40 %, bezogen auf die Gesamtmenge von (a), an Verbindungen mit mindestens einer Urethangruppe im Molekül enthält.

6. Gemisch nach Anspruch 1, **dadurch gekennzeichnet**, daß es 20 bis 60 Gew.-% an Verbindung (a), 0,01 bis 10 Gew.-% an Verbindung (b) und 40 bis 80 Gew.-% an Verbindung (c) enthält.

7. Strahlungsempfindliches Aufzeichnungsmaterial aus einem Schichtträger und einer strahlungsempfindlichen Schicht, die als wesentliche Bestandteile ein durch Strahlung polymerisierbares Gemisch nach Anspruch 1 enthält.

## Claims

1. A radiation-polymerizable mixture, which contains as essential components:

   a) a radical-polymerizable compound with at least one terminal ethylenically unsaturated group and with a boiling point above 100°C at normal pressure,

   b) a compound which under the action of actinic radiation is able to initiate the polymerisation of the compound (a), and

   c) a saturated mixed polymerisate, insoluble in water and soluble in organic solvents and in aqueous alkaline solutions

   characterised in that the mixed polymerisate contains units of

   c1) 12 - 27 % by weight of a α, β-unsaturated aliphatic carboxylic acid,

   c2) 5 - 60 % by weight of an alkyl methacrylate with 1 to 6 C-atoms in the alkyl group,

   c3) 20 - 50 % by weight of an alkyl acrylate with 4 to 8 C-atoms in the alkyl group and

   c4) 1 - 20 % by weight of styrene which may be substituted and also has an acid number of 78 to 176 and a glass transition temperature of 290 to 330 K.

2. A mixture according to Claim 1, characterised in that the mixed polymerisate contains units (c1) of acrylic acid, methacrylic acid, crotonic acid, sorbic acid, maleic acid, itaconic acid or a half ester of one of the said dicarboxylic acids.

3. A mixture according to Claim 1, characterised in that it contains as component (a) an acrylic- or methacrylic acid ester.

4. A mixture according to Claim 3, characterised in that the component (a) consists at least partially of a compound with at least two terminal ethylenically unsaturated groups.

5. A mixture according to Claim 3, characterised in that the component (a) contains at least 40 %, in relation to the total amount of (a), of compounds with at least one urethane group in the molecule.

6. A mixture according to Claim 1, characterised in that it contains 20 to 60 % by weight compound (a), 0.01 to 10 % by weight compound (b) and 40 to 80 % compound (c).

7. A recording material, sensitive to radiation, of a layer carrier and of a layer sensitive to radiation, which contains as essential components a radiation-polymerizable mixture according to Claim 1.

## Revendications

1. Mélange polymérisable par rayonnement qui contient comme constituants essentiels

   a) un composé polymérisable par les radicaux ayant au moins un groupe éthylénique terminal et un point d'ébullition supérieur à 100°C sous la pression normale,

   b) un composé qui peut amorcer sous l'action d'un rayonnement actinique la polymérisation du composé (a) et

   c) un copolymère saturé insoluble dans l'eau, soluble dans les solvants organiques et dans les solutions aqueuses alcalines,

   caractérisé en ce que le copolymère contient des motifs de

   c1) 12 - 27 % en poids d'un acide carboxylique aliphatique α,β-insaturé,

   c2) 5 - 60 % en poids d'un méthacrylate d'alkyle ayant 1 à 6 atomes de carbone dans le groupe alkyle,

   c3) 20 - 50 % en poids d'un acrylate d'alkyle ayant 4 à 8 atomes de carbone dans le groupe alkyle et

   c4) 1 - 20 % en poids d'un styrène éventuellement substitué

   et présente un indice d'acide de 78 à 176 et une température de transition vitreuse de 290 à 330 K.

2. Mélange selon la revendication 1, caractérisé en ce que le copolymère contient des motifs (c1) d'acide acrylique, d'acide méthacrylique, d'acide crotonique, d'acide sorbique, d'acide maléique, d'acide itaconique ou d'un semi-ester de l'un des acides dicarboxyliques cités.

3. Mélange selon la revendication 1, caractérisé en ce qu'il contient comme constituant (a) un ester acrylique ou méthacrylique.

4. Mélange selon la revendication 3, caractérisé en ce que le constituant (a) consiste au moins partiellement en un composé ayant au moins deux groupes éthyléniques terminaux.

5. Mélange selon la revendication 3, caractérisé en ce que le constituant (a) contient au moins 40 %, par rapport à la quantité totale de (a), de composés ayant au moins un groupe uréthanne dans la molécule.

6. Mélange selon la revendication 1, caractérisé en ce qu'il contient 20 à 60 % en poids de composé (a), 0,01 à 10 % en poids de composé (b) et 40 à 80 % en poids de composé (c).

7. Matériau d'enregistrement sensible au rayonnement consistant en un support de couche et une couche sensible au rayonnement, qui contient comme constituants essentiels un mélange polymérisable par rayonnement selon la revendication 1.